(19) Europäisches Patentamt / European Patent Office / Office européen des brevets

(11) **EP 2 239 843 A1**

(12) **EUROPEAN PATENT APPLICATION**

(43) Date of publication:
**13.10.2010 Bulletin 2010/41**

(51) Int Cl.:
***H03G 3/30*** *(2006.01)*

(21) Application number: **09157665.2**

(22) Date of filing: **08.04.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(71) Applicant: **NXP B.V.**
**5656 AG Eindhoven (NL)**

(72) Inventor: **Leitner, Stefan**
**5656, AE Eindhoven (NL)**

(74) Representative: **Schouten, Marcus Maria et al**
**NXP B.V.**
**IP & L Department**
**High Tech Campus 32**
**5656 AE Eindhoven (NL)**

(54) **Sensitivity adapting transducer**

(57)    According to an embodiment, a sensor assembly (102) for converting ambient sound (104) into output signal (106) is adjusted in its sensitivity by a controller (128) which provides a sensitivity control signal (112), e.g. in the form of a variable bias voltage, to the sensor assembly (102) during operation of the sensor assembly (102). Hence, a bias voltage control may be used as sensitivity control for a microphone during operation. According to a further embodiment, the sensitivity control signal (112) to the sensor assembly (102) is varied so as to provide a dynamic range compression of the output signal (106) of the sensor assembly (102).

Fig. 1

EP 2 239 843 A1

**Description**

Field of the invention

The present invention relates to the field of transducers for converting ambient sound into an output signal.

Art background

US 5,243,657 relates to an electronic circuit for automatically adjusting the sensitivity of a microphone in accordance with changes in ambient noise. A signal is generated which is proportional to the magnitude of the ambient noise and this applied through reverse biased diode to slowly charge a capacitor by means of leakage current. The capacitor is connected to a control input of a sensitivity control circuit connected between the microphone and a device. The sensitivity control circuit is responsive to the signal from the capacitor voltage signal for controlling the sensitivity of the microphone relative to the device. The sensitivity is representative of the magnitude of the output electrical signal generated by the microphone in response to the input acoustic energy sensed thereby. When the magnitude of the ambient noise increases, the capacitor will be slowly charged so as to slowly decrease the sensitivity of the microphone relative to the device. When the magnitude of such ambient noise decreases the capacitor will be rapidly discharged so as to rapidly increase the circuit sensitivity.

In view of the above described situation there exits a need for an improved technique that enables to provide a transducer or a method of operating a sensor assembly providing improved sensitivity characteristics.

Summary of the invention

This need may be met by the subject-matter according to the independent claims. Advantageous embodiments of the herein disclosed subject-matter are described by the dependent claims.

According to a first aspect of the invention, there is provided a transducer comprising a sensor assembly for converting ambient sound into an output signal, the sensor assembly having a sound input for receiving said ambient sound, a sensitivity control input for receiving a sensitivity control signal and a sensor assembly output for providing said output signal. The transducer according to the first aspect further comprises a controller having an output for providing a sensitivity control signal to the sensitivity control input of the sensor assembly to thereby vary the sensitivity of the sensor assembly during operation.

This aspect of the invention is based on the idea that the sensitivity of a sensor assembly can be varied during regular operation of the sensor assembly by varying the sensitivity control signal to the sensor assembly in response to the ambient sound at the sensor assembly.

Generally in this document, the term signal includes radiation signals such as radio signals and/or optical signals, electrical signals, magnetical signals, etc.

According to an embodiment, the sensitivity control signal is varied continuously. According to other embodiments, the sensitivity control signal may be varied discontinuously.

According to a further embodiment, the sensitivity control input is a bias input and the sensitivity control signal is a variable bias voltage. However, the sensitivity control signal depends on the type of the sensor assembly and may hence be any appropriate quantity for changing the sensitivity of the sensor assembly.

For example, according to an embodiment, the sensitiviy of the sensor assembly may be changed by altering the compliance (or stiffness) of a membrane of the sensor assembly. In an embodiment, the compliance of the membrane is altered by applying a respective tensile stress to the membrane. The tensile stress may be applied via MEMS actuators or other suitable means.

According to a further embodiment, the controller is configured for providing the sensitivity control signal to the sensitivity control input of the sensor assembly to thereby change a dynamic range of the output signal. For example, according to a further embodiment, the controller may be configured for providing the sensitivity control signal to the sensitivity control input of the sensor assembly to thereby compress the dynamic range of the output signal. For example, the sensitivity control signal may be provided with a magnitude which leads to compression of the dynamic range of the output signal. Compression of the dynamic range of the output signal may be achieved by reducing the sensitivity of the sensor assembly upon detection of high sound pressure.

For example, according to a further embodiment, the sensor is a capacitor microphone, the control input is a bias input and the sensitivity control signal is a variable bias voltage. In such a case, the bias voltage of a capacitor microphone is decreased for high ambient sound pressure values in order toe achieve compression of the dynamic range of the output signal.

In use cases with high sound pressure levels such a compression of the dynamic range of the output signal may lead to reduced or eliminated hard clipping in the processing chain for processing the output signal. Since compression of the dynamic range is already performed in the transducer itself, the remaining processing chain for processing the output signal of the transducer is automatically free of clipping in one embodiment, where the compression of the dynamic range of the output signal is sufficiently high.

Other embodiments include changing the dynamic range of the output signal by shifting the dynamic range to higher or lower sound pressure levels.

According to a further embodiment of the first aspect, the controller has a control input for receiving an input signal indicative of an ambient sound pressure, wherein the controller is configured for providing the sensitivity control signal in response to the input signal.

This embodiment may provide adaption of the sensitivity of the sensor assembly to the actual ambient sound pressure. For example, in the case of sudden high sound pressures which occur e.g. during drag races, fireworks or on airfields, the sensitivity of the sensor assembly is reduced so as to avoid hard clipping of the output signal of the sensor assembly.

According to a further embodiment of the first aspect, the input signal to the controller is derived from the output signal of the sensor assembly. This embodiment may allow for reduced production costs since no external sensor for sensing the ambient sound pressure for providing the sensitivity control signal is necessary. The input signal may be derived from the output signal in many different ways, depending on the particular application. For example, the input signal may be proportional to the output signal of the sensor assembly. According to another embodiment, the input signal is a mean value of the output signal of the sensor assembly averaged over a predetermined time interval, e.g. a root mean square. According to other embodiments, other processing of the output signal of the sensor assembly is performed to produce the input signal to the controller.

According to a further embodiment of the first aspect, the transducer comprises a further sensor assembly for converting an ambient sound into the input signal of the controller. The input signal of the controller may be derived from the output signal of the further sensor assembly as mentioned before in regard to the output of the first mentioned sensor assembly. Embodiments of this kind may provide a faster response to sound pressure changes of the ambient sound.

According to a further embodiment of the first aspect, the transducer further comprises a level detector for providing the input signal to the controller in the form of a sound pressure level of the ambient sound pressure at an output of the level detector, wherein the output of the level detector is coupled to the input of the controller. It should be mentioned that in this embodiment and generally in this document, coupling includes wired coupling, wireless coupling, etc., via respective signals, e.g. radiation signals such as radio signals and optical signals, electrical signals, magnetical signals, etc.

According to a further embodiment of the first aspect, the controller comprises a control unit having the control input and a control output for providing a control signal. Further, the transducer may have a sensitivity control signal generator for providing the sensitivity control signal in response to the control signal of the control unit. A separate sensitivity control signal generator may provide, according to some embodiments, for a better or easier adaption of the sensitivity control signal to the specifics of the sensor assembly.

According to a second aspect of the herein disclosed subject-matter, a method of operating a sensor assembly for converting ambient sound into an output signal is provided, the method comprising providing a sensitivity control signal to the sensor assembly to thereby vary the sensitivity of the sensor assembly during operation. This allows for adjustment of the sensitivity of the sensor assembly during operation of the sensor assembly.

According to an embodiment of the second aspect, the sensitivity control signal is provided so as to change a dynamic range of an output signal of the sensor assembly. One embodiment of changing the dynamic range of the output signal is to compress the dynamic range of the output signal of the sensor assembly. For example, compression of the dynamic range of the output signal may be achieved by reducing the sensitivity of the sensor assembly upon detection of an increased ambient sound pressure. Other embodiments of changing a dynamic range of the output signal include shifting of the dynamic range.

According to a further embodiment of the second aspect, the method further comprises varying the sensitivity control signal in response to an ambient sound pressure at the sensor assembly. This may provide for an adjustment of the sensitivity of the sensor assembly to the actual ambient sound pressure at the sensor assembly. According to embodiments, the magnitude of the sensitivity control signal is varied in response to the sound pressure measured by the sensor assembly itself. According to other embodiments, the magnitude of the sensitivity control signal is varied in response to a sound pressure measured by another entity, different from the sensor assembly.

According to a further embodiment of the second aspect, the method further comprises deriving the sensitivity control signal from the output signal of the sensor assembly. According to a further embodiment of the second aspect, the method further comprises deriving the sensitivity control signal a further output signal of the sensor assembly, wherein the further output signal is different form the output signal. For example, the further output signal may be provided with a different impedance or by applying a different amplification to a measurement signal compared to the output signal.

According to a further embodiment of the second aspect, the method comprises providing a further sensor assembly different from the sensor assembly, the further sensor assembly providing a further output signal indicative of the ambient sound pressure at the sensor assembly. According to a further embodiment of the second aspect, the method comprises providing the sensitivity control signal to the sensor assembly in response to the further output signal.

According to a third aspect of the herein disclosed subject-matter, an electronic device is provided, the electronic device comprising a transducer according to the first aspect or an embodiment thereof.

According to an embodiment of the third aspect, the electronic device includes a dynamic range compressor for compressing a dynamic range of an ambient sound indicating signal. According to further embodiments, the dynamic range compressor is provided exclusively by a respective embodiment of the transducer, wherein the controller is configured for providing the sensitivity control signal to the sensitivity control input of the sensor assembly to thereby compress a dynamic range of the output signal of the sensor assembly.

According to a fourth aspect of the herein disclosed subject-matter, a computer program for controlling a physical object, namely a sensitivity control signal, is provided, the computer program, when being executed by a data processor, being adapted for controlling the method according to the second aspect or an embodiment thereof.

As used herein, reference to a computer program is intended to be equivalent to a reference to a program element and/or a computer-readable medium containing instructions for controlling a computer system to coordinate the performance of the above-described method according to the second aspect.

The computer program may be implemented as a computer-readable instruction code in any suitable programming language, such as, for example, JAVA, C++, and may be stored on a computer-readable medium (removable disk, volatile or nonvolatile memory, embedded memory/processor, etc.). The instruction code is operable to program a computer or any other programmable device to carry out the intended functions, e.g. the function as defined in aspects and embodiments of the herein disclosed subject-matter. The computer program may be available from a network, such as the WorldWideWeb, from which it may be downloaded. According to an embodiment, the computer program is a program for an embedded processor.

Aspects, embodiments and examples of the herein disclosed subject-matter or any entity thereof may be realized by means of a computer program respectively software. Further, the aspects, embodiments and examples of the herein disclosed subject-matter or entities thereof, may also be realized by means of one or more specific electronic circuits respectively hardware. Furthermore, the aspects, embodiments or examples or any entity thereof may be realized in a hybrid form, i.e. in a combination of software modules and hardware modules.

In the following, there will be described exemplary embodiments of the subject-matter disclosed herein with reference to a transducer and a method of operating a sensor assembly. It has to be pointed out that of course any combination of features relating to different aspects of the herein disclosed subject-matter is also possible. In particular, some embodiments have been described with reference to apparatus type claims whereas other embodiments have been described with reference to method type claims. However, a person skilled in the art will gather from the above and the following description, the claims and the drawings that, unless otherwise notified, in addition to any combination of features belonging to one aspect also any combination between features relating to different aspects or embodiments, for example even between features of the apparatus type claims and features of the method type claims is considered to be disclosed with this application.

The aspects defined above and further aspects of the herein disclosed subject-matter are apparent from the examples and embodiments to be described hereinafter with reference to the drawings, but to which the herein disclosed subject-matter is not limited.

Brief description of the drawings

Fig. 1 shows a transducer according to embodiments of the herein disclosed subject-matter.

Fig. 2 shows another transducer according to embodiments of the herein disclosed subject-matter.

Detailed description

The illustration in the drawings is schematic. It is noted that in different figures, similar or identical elements are provided with the same reference signs or with reference signs which are different from the corresponding reference signs only within the first digit or by an appended character.

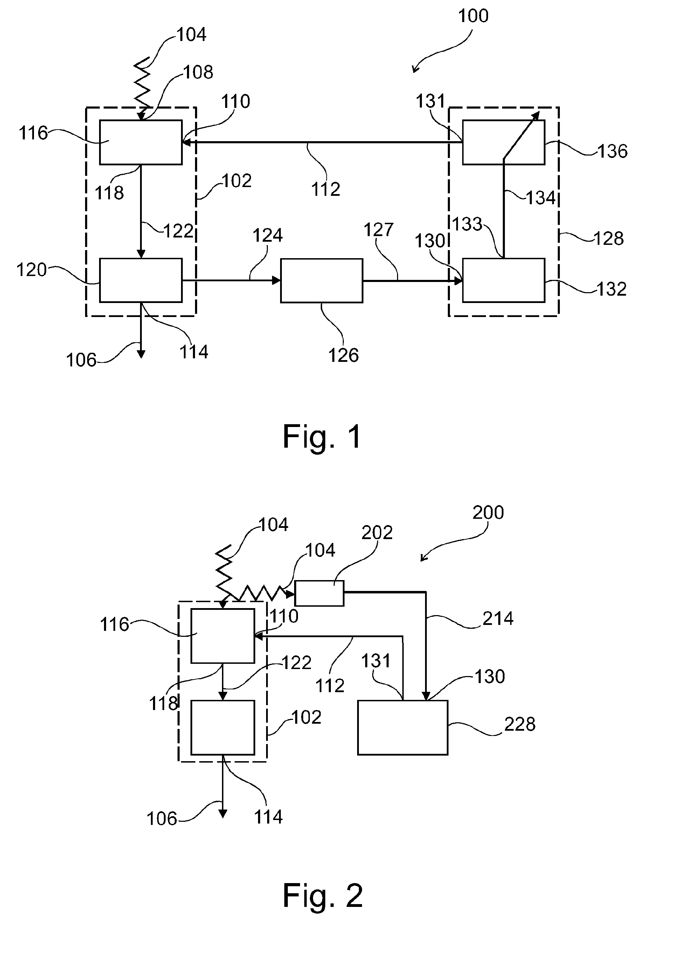

Fig. 1 shows an exemplary transducer 100 in accordance with embodiments of the herein disclosed subject-matter. The transducer 100 comprises a sensor assembly 102 for converting ambient sound 104 into an output signal 106. To this end, the sensor assembly 102 comprises a sound input 108 for receiving the ambient sound 104. Further the sensor assembly comprises a sensitivity control input in the form of a bias input 110 for receiving a sensitivity control signal in the form of a bias voltage 112 and a sensor assembly output 114 for providing the output signal 106.

According to an embodiment, the sensor assembly 102 comprises a sensor 116 which provides the sound input 108. The sensor 116 may be for example a capacitor microphone. According to an embodiment, the sensor 116 is a microelectromechanical system (MEMS) sensor. The sensor 116 has a sensor output 118. Further, the sensor assembly 102 comprises a readout electronics 120 which is coupled to the sensor output 118 for reading out sensor values 122 out of the sensor 116. In response to the sensor values 122 the readout electronics provides the output signal 106 at the sensor assembly output 114.

According to an embodiment, the readout electronics provides a certain amplification of the measured sensor values 122. According to a further embodiment, the readout electronics provides a predetermined impedance at the output 114.

According to an embodiment, the readout electronics 120 provides a second output 124 to a level detection module 126 of the transducer 100, as shown in Fig. 1. The second output may differ from the first output e.g. in amplification or impedance. The second output 124 of the readout electronics 120 is indicative of an ambient sound pressure of the ambient sound 104. According to an embodiment, the level detection module 126 determines an mean value of the second output signal 124 by averaging the second output signal 124 over a predetermined time period.

According to an embodiment, the readout electronics 120 comprises an amplifier and/or an impedance converter. In such a case, the transducer 100 may be an analogue circuit. According to another embodiment, the readout electronics 120 alternatively or additionally comprises an analog-digital converter (ADC) for providing the second output 124 in the form of a digital signal. In such a case the transducer 100 may be a digital circuit.

The level detection module 126 provides an input signal 127 indicative of the ambient sound pressure at the sensor 116 to a controller 128 of the transducer 100.

The controller 128 comprises a control input 130 for receiving the input signal 127 and a controller output 131 for providing the sensitivity control signal 112. According to an embodiment, the control input 130 is provided by a control unit 132 of the controller 128. The control unit 132 provides a control signal 134 to a sensitivity control signal generator 136 of the controller 128 in response to the input signal 127.

The sensitivity control signal generator 136 provides, in response to the control signal 134, the sensitivity control signal 112 in the form of the varying bias voltage to the sensor assembly 102 and in particular to the bias input 110 of the sensor 116.

According to an exemplary embodiment, the transducer 100 is configured for dynamic range compression of the output signal 106.

Dynamic range compression (also called audio level compression, volume compression, compression or limiting) is a process that manipulates the dynamic range of an audio signal. Compression is used during sound recording, life sound reinforcement and broadcasting to alter the perceived volume of audio. A compressor is the device used to create compression, e.g. the device used to change a relationship between at least two of an input level, an output level, and a gain reduction. In simple terms a compressor may be regarded as an automatic volume control. Loud sounds over a certain threshold are reduced in the level, while quiet sounds are not reduced. In this way, the dynamic range of an audio signal is reduced (compressed). This may be done for aesthetic reasons, to deal with technical limitations of audio equipment, or to improve audibility of audio in noisy environments, just to name some examples. In a noisy environment background noise can overpower quiet sounds. A comfortable listening level for loud sounds makes the quiet sounds inaudible: A comfortable listening level for quiet sounds makes the loud sounds too loud. To make both the soft and loud parts of a sound audible at the same time, compression is used. Compression reduces the level of the loud sound but not of the quiet sounds, thus, the level can be raised to a point where the quiet sounds are audible but without the loud sounds being too loud.

Typical examples of use cases where (dynamic range) compression might be employed are wind noise (high low frequency content audio signal) and use cases with high sound pressure levels such as drag race, fireworks, airfield, just to name a few. The sound pressure levels in such use cases often lead to hard clipping the recording chain. Hard clipping leads to very audible distortion that is sometimes not acceptable. Potential candidates for hard clipping in a digital microphone component are an input to a pre-amplifier, a pre-amplifier or an analog-digital converter. The weakest link in the recording chain or, more general in the sound processing chain, determines the performance. Therefore, it is important that clipping is prevented in every part of the sound processing chain.

The sensitivity *s* of the MEMS microphone is computed as

$$s = (A \cdot C \cdot U) / d \qquad (1)$$

wherein A is the area, C is the compliance, U is the bias voltage and d is the distance. Equation (1) for the sensitivity *s* is valid in the case that the capacitor of the microphone can be approximated by a plate capacitor. Further, as can be seen from the above equation (1), if the bias voltage U is high, also the sensitivity *s* is high. Hence, according to an

EP 2 239 843 A1

embodiment, the sensitivity s is proportional to the bias voltage U, indicated at 112 in Fig. 1.

According to an embodiment, the bias voltage for the MEMS sensor is controlled in a way that high sound pressure level signals lead to a reduced sensitivity of the MEMS sensor 118. Hard clipping is avoided at the very beginning of the audio chain. Hence, according to an embodiment, no further activities within the audio chain for clipping protection are necessary.

Fig. 2 shows a further transducer 200 according to embodiments of the herein disclosed subject-matter. Components which are identical to respective components of the transducer 100 of Fig. 1 are denoted by the same reference signs and the description of these components is not repeated here.

According to an embodiment, shown in Fig. 2, the transducer 200 comprises a further sensor assembly 202 for converting an ambient sound 104 into the input signal 214 for a controller 228. The further sensor assembly 202 may be of a kind different from the kind of the sensor assembly 102. For example, the further sensor assembly 202 may be adapted for providing said input signal 214 in the form of an average sound pressure level to the controller 228.

The controller 228 provides in response to the input signal 214 the varying bias voltage 112 to the sensor assembly 102, e.g., as shown in Fig. 2, to the bias input 110 of the sensor 116. In this way, one or more of the herein disclosed objects and advantages are achieved by the transducer 200. According to an embodiment, the controller may be a single entity, as shown in Fig. 2. Further, according to other embodiments, the controller may include two or more components, as is exemplarily shown in Fig. 1.

According to embodiments of the herein disclosed subject-matter, any component of a transducer, e.g. the readout electronics, the level detection module, the control unit, the sensitivity control signal generator, or the controller are provided in the form of respective computer program products which enable a processor to provide the functionality of the respective elements as disclosed herein. According to other embodiments, any component of a transducer, e.g. the readout electronics, the level detection module, the control unit, the sensitivity control signal generator or the controller may be provided in hardware. According to other - mixed - embodiments, some components may be provided in software while other components are provided in hardware.

It should be noted that the term "comprising" does not exclude other elements or steps and that "a" or "an" does not exclude a plurality. Also elements described in association with different embodiments may be combined. It should also be noted that reference signs in the claims should not be construed as limiting the scope of the claims.

Further, it should be noted that in accordance with the scope of the claims variations can be performed with regard to the transducers in Fig. 1 and Fig. 2. For example, instead of using the further output signal 124 as an input for the level detection module 126 in Fig. 1, also the output signal 106 could be used as input signal to the level detection module 126. Many other such variations will be apparent to the person skilled in the art from the herein disclosed subject-matter and the drawings. Further, although the sensor assembly 102 includes a readout electronics, this is not necessarily the case. Rather, according to other embodiments, the sensor assembly may consist only of the sensor 116 or may include other components.

In order to recapitulate the above-described embodiments of the herein disclosed subject-matter one can state:

According to an embodiment, a sensor assembly for converting ambient sound into output signal is adjusted in its sensitivity by a controller which provides a sensitivity control signal, e.g. in the form of a variable bias voltage, to the sensor assembly during operation of the sensor assembly. Hence, a bias voltage control may be used as sensitivity control for a microphone during operation. According to a further embodiment, the sensitivity control signal to the sensor assembly is varied so as to provide a dynamic range compression of the output signal of the sensor assembly.

List of reference signs:

| | |
|---|---|
| 100, 200 | transducer |
| 102, 202 | sensor assembly |
| 104 | ambient sound |
| 106 | output signal |
| 108 | sound input |
| 110 | sensitivity control input |
| 112 | sensitivity control signal |
| 114, 214 | sensor assembly output |
| 116 | sensor |
| 118 | sensor output |
| 120 | readout electronics |
| 122 | sensor value |
| 124 | second output of the readout electronics |

| 126 | level detection module |
| 127 | input signal for controller |
| 128, 228 | controller |
| 130 | control input of controller |
| 132 | control unit |
| 134 | control signal of control unit |
| 136 | sensitivity control signal generator |

**Claims**

1.  Transducer (100, 200) comprising:

    a sensor assembly (102) for converting ambient sound (104) into a output signal (106), said sensor assembly (102) having a sound input (108) for receiving said ambient sound (104), an sensitivity control input (110) for receiving a sensitivity control signal (112) and an sensor assembly output (114) for providing said output signal (106); and
    a controller (128, 228) having an output (131) for providing a sensitivity control signal (112) to said sensitivity control input (110) of said sensor assembly (102) to thereby vary the sensitivity of said sensor assembly (102) during operation.

2.  Transducer according to claim 1, wherein said controller (128) is configured for providing said sensitivity control signal (112) to said sensitivity control input (110) of said sensor assembly (102) to thereby change a dynamic range of said output signal (106).

3.  Transducer according to claim 1 or 2, wherein
    said sensitivity control input (110) is a bias input;
    said sensitivity control signal (112) is a bias voltage.

4.  Transducer according to one of the preceding claims,
    said controller (128, 228) having an control input (130) for receiving an input signal (127, 214) indicative of an ambient sound pressure of said ambient sound (104), and
    said controller (128, 228) being configured for providing said sensitivity control signal (112) in response to said input signal (127, 214).

5.  Transducer according to claim 4, said input signal (127, 214) to said controller (128, 228) being derived from said output signal (106) of said sensor assembly (102).

6.  Transducer according to claim 4,
    further comprising a further sensor assembly (202) for converting said ambient sound (104) into said input signal (214) of said controller (228).

7.  Transducer according to one of claims 4 to 6, further comprising a level detector (126) for providing said input signal (127) in the form of a sound pressure level of said ambient sound (104) to said input (130) of said controller (128).

8.  Transducer according to one of the preceding claims, wherein the controller (128, 228) comprises:

    a control unit (132) having said control input (130) and a control output (133) for providing a control signal (134); and
    a sensitivity control signal generator (136) for providing said sensitivity control signal (112) in response to control signal (134).

9.  Method of operating a sensor assembly (102) for converting ambient sound (104) into an output signal (106), said method comprising:

    providing a sensitivity control signal (112) to said sensor assembly (102) to thereby vary the sensitivity of said sensor assembly (102) during operation.

10. Method according to claim 9, wherein providing said sensitivity control signal (112) comprises providing said sensitivity control signal (112) to thereby change a dynamic range of said output signal (106) of said sensor assembly.

11. Method according to claim 10, wherein providing said sensitivity control signal (112) comprises providing said sensitivity control signal (112) to thereby compress a dynamic range of said output signal (106) of said sensor assembly (102).

12. Method according to one of claims 9 to 11, the method further comprising:

varying said sensitivity control signal (112) in response to an ambient sound pressure of said ambient sound (104) at said sensor assembly (102).

13. Method according to claim 12, the method further comprising:

deriving said sensitivity control signal (112) from said output signal (106) of said sensor assembly (102).

14. Method according to claim 12, the method further comprising:

providing a further sensor assembly (202) different from said sensor assembly (102), said further sensor assembly (202) providing a further output signal (214) indicative of said ambient sound pressure of said ambient sound (104) at said sensor assembly (102);
providing said sensitivity control signal (112) to said sensor assembly (102) in response to said further output signal (214).

15. Computer program for controlling a physical object, namely a sensitivity control signal (112), the computer program, when being executed by a data processor, being adapted for controlling the method as set forth in any one of the claims 8 to 13.

Fig. 1

Fig. 2

Europäisches
Patentamt

European
Patent Office

Office européen
des brevets

# EUROPEAN SEARCH REPORT

Application Number

EP 09 15 7665

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 199 34 747 A1 (SIEMENS AG [DE]) 25 January 2001 (2001-01-25) * the whole document * | 1-13,15 | INV. H03G3/30 |
| X | US 2006/062406 A1 (KINOSHITA HIROSHIGE [JP]) 23 March 2006 (2006-03-23) * figure 5 * | 1-13,15 | |
| X | DE 10 2008 022588 A1 (BLANCHARD HENRIK [DE]) 27 November 2008 (2008-11-27) * figure 5 * | 1-13,15 | |
| X | WO 01/78446 A (MICROTRONIC US INC [US]) 18 October 2001 (2001-10-18) * abstract; figures 3,10,11,13 * | 1-13,15 | |

TECHNICAL FIELDS
SEARCHED     (IPC)

H03G
H04R

~~The present search report has been drawn up for all claims~~

| Place of search | Date of completion of the search | Examiner |
|---|---|---|
| Munich | 10 September 2009 | Fritzsche, H |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

...............................................................................

& : member of the same patent family, corresponding
    document

EPO FORM 1503 03.82 (P04C01)

Europäisches
Patentamt

European
Patent Office

Office européen
des brevets

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-13, 15

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 09 15 7665

The Search Division considers that the present European patent application does not comply with the
requirements of unity of invention and relates to several inventions or groups of inventions, namely:

```
    1. claims: 1-13,15

        transducer with sensitivity control by deriving a
        sensitivity control signal from the output signal
                            ---

    2. claim: 14

                transducer with two sensors
                        ---
```

EP 2 239 843 A1

## ANNEX TO THE EUROPEAN SEARCH REPORT
## ON EUROPEAN PATENT APPLICATION NO.

EP 09 15 7665

This annex lists the patent family members relating to the patent documents cited in the above-mentioned European search report.
The members are as contained in the European Patent Office EDP file on
The European Patent Office is in no way liable for these particulars which are merely given for the purpose of information.

10-09-2009

| Patent document cited in search report | | Publication date | Patent family member(s) | | Publication date |
|---|---|---|---|---|---|
| DE 19934747 | A1 | 25-01-2001 | AU | 5965300 A | 13-02-2001 |
| | | | WO | 0108442 A2 | 01-02-2001 |
| US 2006062406 | A1 | 23-03-2006 | JP | 2006087074 A | 30-03-2006 |
| | | | KR | 20060050531 A | 19-05-2006 |
| DE 102008022588 | A1 | 27-11-2008 | NONE | | |
| WO 0178446 | A | 18-10-2001 | AU | 5097001 A | 23-10-2001 |
| | | | EP | 1192836 A1 | 03-04-2002 |

EPO FORM P0459

For more details about this annex : see Official Journal of the European Patent Office, No. 12/82

13

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 5243657 A